Europäisches Patentamt

European Patent Office

Office européen des brevets

(11) Publication number: 0 392 430
A2

# (12) EUROPEAN PATENT APPLICATION

(21) Application number: 90106788.4

(22) Date of filing: 09.04.90

(51) Int. Cl.5: C01B 13/14, C04B 35/46, H01B 12/00

(30) Priority: 10.04.89 JP 90112/89
20.06.89 JP 157795/89
18.07.89 JP 185516/89

(43) Date of publication of application:
17.10.90 Bulletin 90/42

(84) Designated Contracting States:
DE FR GB

(71) Applicant: MATSUSHITA ELECTRIC
INDUSTRIAL CO., LTD.
1006, Oaza Kadoma
Kadoma-shi Osaka 571(JP)

(72) Inventor: Inoue, Osamu
134-1-901 Okubocho 2-chome
Moriguchi-shi(JP)
Inventor: Adachi, Seiji
6-7-203, Naritacho
Neyagawa-shi(JP)
Inventor: Kawashima, Shunichiro
1223-2, Yatsukacho
Soka-shi(JP)
Inventor: Takahashi, Yukihiro
1343-22 Uenoshibamukogaokacho 4-cho
Sakai-shi(JP)
Inventor: Hirano, Hirofumi
38-1 Kisaichi 6-chome
Katano-shi(JP)

(74) Representative: Patentanwälte Leinweber &
Zimmermann
Rosental 7/II Aufg.
D-8000 München 2(DE)

(54) Oxide superconductor and method of the production thereof.

(57) The present invention provides an oxide superconductive substance comprising a composition containing at least Tl, Bi, Sr, Ca, and Cu, in a ratio of $(Tl + Bi) : Sr : Ca : Cu$ equal or very close to $1 : 2 : 2 : 3$ and in a ratio of Tl/Bi in the range of 5/1 to 2/1 having a crystalline structure of the tetragonal system with the lattice constant, a $= 0.38$ nm, and c $= 1.53$ nm. The present invention provides also a method for producing $(Tl_{1-y}, Bi_y)$-$Sr_2 Ca_2 Cu_3 O_x$ oxide superconductive substance comprising preparing a starting material containing metal oxide components in a ratio of $(Tl_{1-y}, Bi_y) : Sr : Ca : Cu : O = (1 + Z) : 2 : 2 : 3 : x$ where $0 \leq y \leq 1/3$, and the value of x is in the range of $(7.5 + 1.5Z) \leq x \leq (8.3 + 1.5Z)$, and sintering said starting material in a non-oxidizing atmosphere.

# OXIDE SUPERCONDUCTOR AND METHOD OF THE PRODUCTION THEREOF

## BACKGROUND OF THE INVENTION

### Field of the Invention

The present invention relates to an oxide superconductor and a method of producing the oxide superconductor, and more particularly, to a thallium-containing oxide superconductor having a lower content of thallium and a higher critical temperature.

### Description of the Related Art

Superconductive materials have unique characteristics such as 1) zero electric resistivity, 2) complete diamagnetism, and 3) Josephson effect, which are not found in other materials, and may be expected to be used in extensive applications including a power transmission, generator, nuclear fusion plasma confinement, magnetically levitating vehicle, magnetic shield, and high speed computer. However, conventional metal based superconductors have a superconductive transition temperature on the order of $23^\circ$ K at most, and require in practical use a high level of cooling using expensive liquid helium and a heavy adiabatic system which are great difficulties in industry. Therefore, a research has been made to find materials having a higher superconductive transition temperature.

In 1986, Bednorz and Müller working for IBM discovered oxide based superconductive $(La_{1-z}Sr_z)_2CuO_x$ having a superconductive transition temperature as high as about $40^\circ$ K. Since then, there have been reported successively higher superconductive transition temperatures in the systems of $YBa_2Cu_3O_x$, Bi-Sr-Ca-Cu-O, and Tl-Ba-Ca-Cu-O. As superconductors are higher in the superconductive transition temperature, they can be cooled easier, and are expected to exhibit a higher critical current density and a higher critical magnetic field intensity in the use at a given temperature so that they will be applied to much more varied areas. Thus, recently, many researches have been made to processes for producing such superconductive materials, and physical properties and applications thereof.

Among these materials, the $(La_{1-z}Sr_z)_2CuO_x$ has a superconductive transition temperature of $40^\circ$ K or less, making it impossible to use in expensive liquid nitrogen for cooling. Though the $YBa_2Cu_3O_x$ has a transition temperature of about $90^\circ$ K which is higher than the temperature of liquid nitrogen, the difference therebetween is still small, and the atmosphere at the time of sintering must be controlled. The Bi-Sr-Ca-Cu-O system has a transition temperature over $100^\circ$ K, but produces a problem that it must be sintered for a longer period of time at around its melting temperature to produce a single phase. In contrast, the Tl-Ba-Ca-Cu-O system has the maximum transition temperature of about $120^\circ$ K which is the most excellent from the standpoint of transition temperature. However, it has a high content of very poisonous thallium, and a melting point as low as $920^\circ$ C so that it must be sintered at around its melting point. Owing to liability to evaporation of thallium, the system can produce many compounds having different transition temperatures with different contents of Tl, Ca and Cu (there are 2212, 2223, 2234, 2245, 1212, 1223, 1234 and the like in terms of a molar ratio of Tl, Ba, Ca and Cu). The system have suffered from difficulties in controlling sintering conditions and the like in order to synthesize superconductive materials having a consistent transition temperature,

On the other hand, Tl-Sr-Ca-Cu-O system ceramics produced from Tl-Ba-Ca-Cu-O by substituting Sr for Ba thereof have a melting point of $1000^\circ$ C or higher with a tolerance to possible sintering temperatures, and can produce only two sorts of compounds (identified as 1212, and 1223 in terms of a molar ratio of Tl, Sr, Ca and Cu), so that they may be expected to form more easily a single phase. With this system, however, it has been difficult to produce ceramics having a superconductive transition temperature above the liquid nitrogen temperature. For example, even when samples having an onset temperature on the order of $100^\circ$ K were produced, most of them had a zero resistance temperature of $50^\circ$ K or lower.

Although $(Tl,Bi)Sr_2CaCu_2O_x$ phases produced from a combination of the Bi-Sr-Ca-Cu-O and the Tl-Ba-Ca-Cu-O have been discovered, they have a superconductive transition temperature as low as $80^\circ$ K.

## SUMMARY OF THE INVENTION

2

It is an object of the present invention to provide a thallium-containing oxide superconductor having a low content of poisonous thallium and a critical temperature near 120° K.

It is another object of the present invention to provide a process for producing a thallium-containing oxide superconductor as a single phase.

It is still another object of the present invention to provide a process for producing an oxide superconductor or a single phase superconductive ceramic of a crystalline structure in the tetragonal system with the lattice constant, a = 0.38 nm, b = 1.53 nm, which comprises a composition containing at least Tl, Bi, Sr, Ca and Cu without the disadvantages of prior oxide superconductors as described above.

## DESCRIPTION OF PREFERRED EMBODIMENTS

The present inventors have made an intensive research on novel compositions capable of producing high temperature oxide superconductors in terms of a ratio of components, and as a result, discovered a ceramic having the aforementioned composition and structure and exhibiting the maximum superconductive transition temperature near 120° K. This superconductor has a higher transition temperature, but has a lower content of highly poisonous Tl of about 12 to 13 mol % at most, which is only on the order of 1/2 of about 22 mol % Tl contained in the high critical temperature phase, $Tl_2Ba_2Ca_2Cu_3O_x$ of the Tl-Ba-Ca-Cu-O system, and has a higher melting temperature than that of the $Tl_2Ba_2Ca_2Cu_3O_x$ as well as a higher stability than the latter at the same temperature. From a research on processes, we also have developed a method for producing the single phase ceramic. This method is useful for production of $TlSr_2Ca_2Cu_3O_x$ phase containing no Bi, and effective to facilitate synthesis of a single phase as well as to increase its transition temperature. The following Examples 1 and 2 illustrate the compositions in terms of a ratio of components, and the crystalline structures of the superconductors in accordance with the present invention, and Examples 3 and 4 illustrate the method for production of the single phase ceramics.

### Example 1

As starting materials, powders of $Tl_2O_3$, $Bi_2O_3$, $SrCO_3$, $CaCO_3$ and CuO having a purity of 99 % or more were employed. From them, $SrCO_3$ and CuO powders were weighed in a ratio of Sr : Cu = 2 : 1 to the total weight of 30 g, and mixed by milling on a vibration mill with $ZrO_2$ balls of a diameter of 2 mm in 40 ml ethanol as dispersion medium for one hour. After finished mixing, the whole together with the dispersion medium was dried in a drying apparatus at 120° C. The resultant powder was calcined in air at 1000° C for 5 hours, then milled on the vibration mill for 30 min. in the same manner as described above, and dried at 120° C. X-ray diffraction analysis revealed that $Sr_2CuO_3$ has been formed in the calcined powder. In the same way, $CaCO_3$ and CuO powders treated and calcined at 950° C to synthesize $Ca_2CuO_3$ powders. These $Sr_2CuO_3$ and $Ca_2CuO_3$ powders were analyzed for component ratios to confirm that there was no deviation from the desired composition. These $Sr_2CuO_3$ and $Ca_2CuO_3$ powders, and also $Tl_2O_3$, $Bi_2O_3$ and CuO powders were weighed to the total weight of 20 g in a molar ratio of Tl : Bi : Sr : Ca : Cu = 2 : 0.5 : 2 : 3 : 4. The weighed powders were mixed by means of a grinding machine for one hour. After finished mixing, 0.4 g of the resulting powder was shaped by uniaxially pressing on a metal mold of 15 mm x 15 mm under a pressure of 500 kg/cm². The shape was wrapped with a Au foil, confined in a quartz tube under sub-atmospheric pressure (about $10^{-2}$ Torr), and sintered in an electric furnace at a temperature of 900 to 950° C for 1 to 40 hours. Rising or descending rate of temperature were 400° C/hr, in all cases.

Silver electrodes were attached to the sintered ceramics which were measured for the dependency of electric resistivity upon temperature by the four- terminal technique from 300° K to 5° K at 10 mA to determine a temperature at which a rapid reduction of electric resistivity commences due to superconductive transition (T1), and zero resistance temperature (T2). Moreover, the sintered ceramics were measured for the dependency of magnetic susceptibility to determine a temperature at which a rapid variation of the magnetic susceptibility commences (T3). The results are shown in Table 1.

Table 1.

| Characteristics of sintered ceramics | | | | | | | |
|---|---|---|---|---|---|---|---|
| Sintering | | Resistance ($\Omega$) | | | Transition Temperature ($^\circ$K) | | |
| Temperature | Time | 300K | 150K | 50K | T1 | T2 | T3 |
| 850$^\circ$C | 5 h | 0.43 | 0.36 | 0 | 72 | 66 | 64 |
| 850$^\circ$C | 20 h | 0.27 | 0.19 | 0 | 84 | 77 | 78 |
| 900$^\circ$C | 5 h | 0.24 | 0.16 | 0 | 112 | 71 | 80 |
| 900$^\circ$C | 20 h | 0.12 | 0.08 | 0 | 112 | 74 | 82 |
| 925$^\circ$C | 5 h | 0.41 | 0.37 | 0 | 103 | 70 | 72 |
| 925$^\circ$C | 20 h | 0.08 | 0.05 | 0 | 112 | 72 | 110 |
| 925$^\circ$C | 40 h | 0.10 | 0.05 | 0 | 114 | 101 | 111 |
| 950$^\circ$C | 5 h | 0.06 | 0.04 | 0 | 106 | 70 | 103 |
| 950$^\circ$C | 20 h | 0.15 | 0.11 | 0.01 | 108 | 34 | 105 |
| T1: Electric resistance reduction onset temperature (Tc onset) T2: Zero electric resistance temperature (Tc R = 0) T3: Meissner effect commencing temperature | | | | | | | |

As can be clearly seen from Table 1, the sintering temperature of 900$^\circ$C or higher resulted in the onset temperature Tc over 100$^\circ$K observed and in the zero resistance temperature over 100$^\circ$K by sintering for 40 hours at 925$^\circ$C.

X-ray diffraction analysis on these sintered ceramics after comminuted revealed that the samples sintered at 850$^\circ$C had a major phase of the tetragonal system with a = 0.35 nm and c = 1.21 nm, which phase was considered identical to the previously reported $(Tl,Bi)Sr_2CaCu_2O_x$ phase, and had a Tc of about 80$^\circ$K. On the other hand, the samples sintered at 900$^\circ$C or higher were observed to have a phase of the tetragonal system with a = 0.38 nm and c = 1.53 nm formed. The samples sintered at 925$^\circ$C for 40 hours had a major phase of that type with c = 1.53 nm. As impurities, there were coexisted small amounts of $Ca_2CuO_3$, CuO and a phase of c = 1.21 nm. Since samples sintered at 925$^\circ$C for 40 hours had the maximum Tc, this phase of c = 1.53 nm is a superconductive phase in this system.

Example 2

In the same manner as in Example 1, $Sr_2CuO_3$ and $Ca_2CuO_3$ powders and also $Tl_2O_3$, $Bi_2O_3$ and CuO powders were weighed to the total weight of 20 g in molar ratios as shown in Table 2. The ratios of Tl : Sr : Ca : Cu were 2 : 2 : 3 : 4 and 2 : 2 : 2 : 3. The above ratios will be referred to as (2234) and (2223), respectively, hereafter.

Weighed powders were mixed, shaped, sintered, and the sintered shapes were measured for superconductive transition temperature. The results are shown in Table 3.

4

Table 2.

| Compositions in terms of a ratio of components | | | | | |
|---|---|---|---|---|---|
| No. | Tl | Bi | Sr | Ca | Cu |
| 1 | 2.0 | 0.0 | 2.0 | 3.0 | 4.0 |
| 2 | 2.0 | 0.1 | 2.0 | 3.0 | 4.0 |
| 3 | 2.0 | 0.2 | 2.0 | 3.0 | 4.0 |
| 4 | 2.0 | 0.25 | 2.0 | 3.0 | 4.0 |
| 5 | 2.0 | 0.33 | 2.0 | 3.0 | 4.0 |
| 6 | 2.0 | 0.4 | 2.0 | 3.0 | 4.0 |
| 7 | 2.0 | 0.0 | 2.0 | 2.0 | 3.0 |
| 8 | 2.0 | 0.25 | 2.0 | 2.0 | 3.0 |
| 9 | 2.0 | 0.4 | 2.0 | 2.0 | 3.0 |

Table 3.

| Characteristics of sintered ceramics | | | | | | | |
|---|---|---|---|---|---|---|---|
| Composition No. | Sintering | | Resistance ($\Omega$) | | Transition Temperature ($^\circ$K) | | |
| | Temperature | Time | 150K | 15K | T1 | T2 | T3 |
| 1 | 975 $^\circ$C | 5 h | 1.6 | 0.15 | 89 | <15 | 77 |
| 2 | 975 $^\circ$C | 5 h | 0.94 | 0 | 94 | 17 | 80 |
| 3 | 975 $^\circ$C | 5 h | 0.055 | 0 | 112 | 100 | 98 |
| 4 | 975 $^\circ$C | 5 h | 0.022 | 0 | 110 | 101 | 102 |
| 5 | 975 $^\circ$C | 5 h | 0.023 | 0 | 112 | 103 | 104 |
| 6 | 975 $^\circ$C | 5 h | 0.028 | 0 | 116 | 112 | 112 |
| 7 | 975 $^\circ$C | 5 h | 0.66 | 0.19 | 78 | <15 | <15 |
| 8 | 975 $^\circ$C | 5 h | 0.070 | 0 | 105 | 100 | 103 |
| 9 | 975 $^\circ$C | 5 h | 0.03 | 0 | 99 | 90 | 92 |
| 1 | +850 $^\circ$C | 100 h* | 12 | 0.44 | 77 | <15 | <15 |
| 4 | +850 $^\circ$C | 100 h* | 0.014 | 0 | 114 | 109 | 110 |
| 6 | +850 $^\circ$C | 100 h* | 0.012 | 0 | 117 | 114 | 115 |
| 8 | +850 $^\circ$C | 100 h* | 0.013 | 0 | 111 | 84 | 109 |

\* sintered at 975 $^\circ$C for 5 hours and then at 850 $^\circ$C for 100 hours

As can clearly be seen from Table 3, the sintering at 950 $^\circ$C for 5 hours resulted in a superconductive transition onset temperature of 90 $^\circ$K or lower and a zero resistance temperature of 15 $^\circ$K or higher as determined by measurement of resistance in both the compositions in the ratios of (2234) and (2223) having no Bi added. In contrast, the addition of 0.1 of Bi led to a zero resistance temperature of 15 $^\circ$K or higher observed, and the addition of 0.2 or more of Bi to the composition in the ratio of (2234) resulted in an onset temperature of 110 $^\circ$K or higher, and a zero resistance temperature of 100 $^\circ$K or higher. The composition in the ratio of (2223) could produce superconductors exhibiting a transition temperature near 100 $^\circ$K by addition of Bi. When the sintering conditions were 975 $^\circ$C for 5 hours plus 850 $^\circ$C for 100 hours, the samples having no Bi added has a higher resistance in the ordinary conductive state, and exhibited no onset of zero resistance and Meissner effect, though the onset of resistance variation was observed. The analysis of these samples for component ratios indicated little inclusion of Tl. This is considered for evaporation of Tl due to a long period of sintering time. In contrast to this, the compositions with addition of Bi, particularly those in the ratio (2234), attained the maximum onset temperature of 117 $^\circ$K and zero resistance temperature of 114 $^\circ$K. The analysis for component ratios indicated that about one half of the incorpoarted Tl remained.

From these sintered samples, portions of those having a higher transition temperature were ground, and identified for produced phases by powder X-ray diffraction analysis as well as by EPMA compositional analysis for crystalline grains on the broken surfaces of the sintered bodies. In the Tl-Sr-Ca-Cu-O system, there have been reported existence of phases having a component ratio of Tl-Sr-Ca-Cu-O of approximately $1 : 2 : 1 : 2$, and those of $1 : 2 : 2 : 3$. These phases will be referred to as "1212" phase and "1223" phase, respectively. X-ray diffraction analysis indicated that the samples tested here without addition of Bi for both the compositions in the ratios (2234) and (2223) produced the "1212" phase and unknown phases by sintering at 975°C for 5 hours, and only unknown phases by sintering at 970°C for 5 hours plus at 850°C for 100 hours. These unknown phases were confirmed to contain little Tl atoms, if any. On the other hand, X-ray diffraction analysis revealed that the samples having 0.2 or more Bi added exhibited two types of diffraction patterns similar to the "1212" phase and the "1223" phase in the Tl-Sr-Ca-Cu-O system, respectively. One of them had the lattice constant, $a = 0.35$ nm, and $c = 1.21$ nm (tetragonal), and the other had $a = 0.38$ nm, and $c = 1.53$ nm. The former had the same crystalline structure as that of the "1212" phase, which had been previously reported as $(Tl,Bi)Sr_2CaCu_2O_x$ of the Tl-Sr-Ca-Cu-O system having a part of Tl atoms thereof replaced by Bi atoms and as having a Tc of approximately 80°K. On the other hand, the latter was similar to the "1223" phase, and also considered to be $(Tl,Bi)Sr_2Ca_2Cu_3O_x$ phase of the Tl-Sr-Ca-Cu-O system having a part of Tl atoms thereof replaced by Bi atoms. EPMA analysis indicated production of crystals of $Tl + Bi : Sr : Ca : Cu = 1 : 2 : 2 : 3$. These Bi-containing phases will be referred to as "1212" like phase and "1223" like phase, respectively.

Comparing the composition in the ratio of (2234) with that of (2223) among Bi added oxides, the (2234) composition produced the "1223" like phase as major phase and the "1212" like phase as minor phase, while the (2223) composition produced much higher amount of the "1212" like phase than the "1223". From the fact that samples Nos. 4 and 6 had a higher transition temperature than that of samples Nos. 8 and 9 as shown in Table 2, it could be concluded that the "1223" like phase is a superconductor having a transition temperature over 110°K. Though its composition may be approximately $(Tl,Bi)Sr_2Ca_2Cu_3O_x$, the composition in the ratio of (2234) had to be employed in order to increase yield. In such case, however, excess of Ca and Cu atoms are maturally present leading to formation of impurities with them as confirmed by X-ray diffraction and EPMA analysis.

In the next place, the ratio of $(Tl + Bi)/Bi$ in the $(Tl,Bi)Sr_2Ca_2Cu_3O_x$ phase was analyzed by EPMA. With an addition of Bi of 0.2 and 0.33, the average ratios were approximately 1/0.22 and 1/0.29, respectively. Even with an addition of Bi of 0.4, it was 1/0.31, and higher proportion of Bi to be added resulted in little increase of the average value. On the other hand, an addition of Bi of 0.1, had less clearly an effect on improving characteristics as shown in Table 3. Therefore, the addition of Bi contributes to an improvement of transition temperature, and particularly the ratio of Tl/Bi should be preferably in the range of 5/1 to 2/1.


Example 3

As discussed in Examples 1 and 2, the superconductors in accordance with the present invention are of a phase having a crystalline structure of the tetragonal system with lattice constant, $a = 0.38$ nm, and $b = 1.53$ nm identified as having approximately a composition of $(Tl,Bi)Sr_2Ca_2Cu_3O_x$ produced from the $TlSr_2Ca_2Cu_3O_x$ composition by replacing a part of Tl atoms therein with Bi atoms. In ordinary processes, however, that phase could be produced only a little without employing as starting materials compositions comprising excess of Ca and Cu components, which made it difficult to produce a single phase of the $(Tl,Bi)Sr_2Ca_2Cu_3O_x$. Moreover, the $TlSr_2Ca_2Cu_3O_x$ phase itself is difficult to produce by ordinary processes, there were many cases where ceramics produced had an onset temperature on the order of 90°K, but had no zero resistance observed. At first, therefore, synthesis of the $TlSr_2Ca_2Cu_3O_x$ phase which corresponds to $(Tl_{1-y}, Bi_y)Sr_2Ca_2Cu_3O_x$ with $y = 0$ was studied from the standpoint of starting materials.

As starting materials, besides $Tl_2O_3$, $Bi_2O_3$, $CuO$, $Sr_2CuO_3$, and $Ca_2CuO_3$ powders used in Example 1, the powders of $Tl_2O$, $Cu_2O$ and $Cu$ were used.

The $Sr_2CuO_3$, and $Ca_2CuO_3$ powders were synthesized in the same manner as in Example 1. These powders and $Tl_2O$, $Tl_2O_3$, $Bi_2O_3$, $CuO$, $Cu_2O$ and $Cu$ powders were weighed to achieve the molar ratio of Tl : Sr : Ca : Cu = $1 + Z : 2 : 2 : 3$, and the stated proportions of $Tl_2O$ and $Tl_2O_3$, and the stated proportions of $CuO$, $Cu_2O$ and $Cu$ metal as in Table 4. The total weight was 5 g in all cases. Though the end composition is the $TlSr_2Ca_2Cu_3O_x$, tests were conducted with varing $Z = 0$ to 3 because of evaporation of Tl during sintering.

Weighed powders were mixed, shaped, sintered, and the sintered shapes were measured for superconductive transition temperature. The results are shown in Table 5.

Table 4.

| Compositions in terms of a ratio of components | | | | | | | |
|---|---|---|---|---|---|---|---|
| No. | Z | $Tl^{3+}$ | $Tl^{1+}$ | $Cu^{2+}$ | $Cu^{+}$ | Cu | x |
| 1 | 1 | 2.0 | 0.0 | 3.0 | 0.0 | 0.0 | 10.0 |
| 2 | 1 | 1.9 | 0.1 | 3.0 | 0.0 | 0.0 | 9.9 |
| 3 | 1 | 1.8 | 0.2 | 3.0 | 0.0 | 0.0 | 9.8 |
| 4 | 1 | 1.7 | 0.3 | 3.0 | 0.0 | 0.0 | 9.7 |
| 5 | 1 | 1.5 | 0.5 | 3.0 | 0.0 | 0.0 | 9.5 |
| 6 | 1 | 1.0 | 1.0 | 3.0 | 0.0 | 0.0 | 9.0 |
| 7 | 1 | 0.8 | 1.2 | 3.0 | 0.0 | 0.0 | 8.8 |
| 8 | 1 | 0.5 | 1.5 | 3.0 | 0.0 | 0.0 | 8.5 |
| 9 | 1 | 0 | 2.0 | 3.0 | 0.0 | 0.0 | 8.0 |
| 10 | 1 | 2.0 | 0 | 2.0 | 1.0 | 0.0 | 9.5 |
| 11 | 1 | 2.0 | 0 | 2.5 | 0.0 | 0.5 | 9.5 |
| 12 | 0 | 0.5 | 0.5 | 3.0 | 0.0 | 0.0 | 8.0 |
| 13 | 2 | 2.5 | 0.5 | 3.0 | 0.0 | 0.0 | 11.0 |
| 14 | 3 | 3.5 | 0.5 | 3.0 | 0.0 | 0.0 | 12.5 |

Table 5.

| Characteristics of sintered ceramics | | | | | | |
|---|---|---|---|---|---|---|
| Composition No. | Resistance ($\Omega$) | | | Transition Temperature (°K) | | |
| | 300K | 150K | 15K | T1 | T2 | T3 |
| 1 | 0.40 | 0.62 | 1.26 | 91 | <15 | <15 |
| 2 | 0.37 | 0.46 | 0.38 | 76 | <15 | <15 |
| 3 | 0.24 | 0.22 | 0.0 | 85 | 54 | 82 |
| 4 | 0.12 | 0.13 | 0.0 | 90 | 72 | 84 |
| 5 | 0.054 | 0.033 | 0.00 | 99 | 92 | 90 |
| 6 | 0.092 | 0.058 | 0.00 | 96 | 84 | 86 |
| 7 | insulator | | | <15 | <15 | <87 |
| 8 | insulator | | | <15 | <15 | <15 |
| 9 | insulator | | | <15 | <15 | <15 |
| 10 | 0.11 | 0.06 | 0.00 | 95 | 83 | 91 |
| 11 | 0.71 | 0.85 | 0.0 | 96 | 40 | 91 |
| 12 | 1.1 | 1.4 | 0.0 | 89 | 28 | 82 |
| 13 | 0.39 | 0.21 | 0.0 | 94 | 71 | 77 |
| 14 | 0.26 | 0.25 | 0.0 | 90 | 37 | 35 |

As can be seen from Table 5, with only ordinary $Tl_2O_3$ and CuO, sample No. 1 of Z = 1 had x = 10, no zero resistance observed even at 15°K and no Meissner effect confirmed though some resistivity variation was observed at around 90°K. As a proportion of $Tl_2O_3$ was being reduced by substituting $Tl_2O$ therefor, the composition with x = 9.8 or less exhibited a reducing resistivity at the ordinary conductive state of the sintered ceramic and had both a zero resistance and Meissner effect observed. Sample No. 5 of x = 9.5 had the maximum onset temperature of 99°K, and a zero resistance temperature of 92°K. With further decreasing x, the ceramics until x = 9.0 exhibited a superconductive transition, those of x less than 9.0 had a higher resistivity at the ordinary conductive state and no superconductive transition observed. Sample No. 7 led to Meissner effect observed because of in homogeneity of the sample. Therefore, good superconductive transition was observed in the range of $9.0 \leqq x \leqq 9.8$ with $Z = 1$, that is, $(7.5 + 1.5Z) \leqq x \leqq (8.3 + 1.5Z)$. X-ray diffraction analysis indicated that the resulting samples had the $TlSr_2Ca_2Cu_3O_x$ phase produced.

When $Tl_2O_3$ was replaced by $Cu_2O$ or metal Cu in order to adjust x, or when the value of Z was varied from 0 to 3, samples Nos. 10 to 14 result in enhancement of superconductive characteristics over than those in sample No. 1 with only $Tl_2O_3$ or CuO as clearly seen from the results shown in Table. The present inventors have studied with various compositions in the ratios other than those of samples Nos. 10 to 14, and found that in any case, good superconductive transition could be observed in the range of $(7.5 + 1.5Z) \leqq x \leqq (8.3 + 1.5Z)$. Though the ratio of Sr : Ca : Cu was equal to 2 : 2 : 3, some deviation from this ratio did not give any significant difference in results. No limitation is imposed on the value of Z because of evaporation of Tl. However, too high a value of Z reders the evaporation time-consuming, and excess of Tl prone to remain. Therefore, the value of Z should desirably be one or less. In Examples, the sintering was performed under subatmospheric pressure. The sintering in air or oxygen was less significant in effect on enhancement of characteristics. This is for ease of oxidation of $Tl_2O$, $Cu_2O$ and Cu metal. Therefore, the sintering should be effected in a non-oxidizing atmosphere.

Example 4

Conditions for synthesis of the $(Tl,Bi)Sr_2Ca_2Cu_3O_x$ phases were studied. The $Sr_2CuO_3$, and $Ca_2CuO_3$ powders and $Tl_2O$, $Tl_2O_3$, $Bi_2O_3$, CuO, $Cu_2O$, and Cu powders were weighed to achieve the molar ratio of Tl : Bi : Sr : Ca : Cu = 2 : 0.25 : 2 : 2 : 3, and the stated proportions of $Tl_2O$ and $Tl_2O_3$, and the stated proportions of CuO, $Cu_2O$, and Cu metal as in Table 6. The total weight was 5 g in all cases. Though the end composition was $Tl_{0.75}Bi_{0.25}Sr_2Ca_2Cu_3O_x$, the experiments were performed with excess of Tl component because of evaporation of Tl during sintering.

Weighed powders were mixed, shaped, sintered, and measured for superconductive transition temperature. The results are shown in Table 7.

Table 6.

| Compositions in terms of a ratio of components | | | | | | |
|---|---|---|---|---|---|---|
| No. | Z | $Tl^{3+}$ | $Tl^{1+}$ | $Cu^{2+}$ | $Cu^+$ | Cu | x |
| 1 | 1 | 2.0 | 0.0 | 3.0 | 0.0 | 0.0 | 10.375 |
| 2 | 1 | 1.5 | 0.5 | 3.0 | 0.0 | 0.0 | 9.875 |
| 3 | 1 | 1.0 | 1.0 | 3.0 | 0.0 | 0.0 | 9.375 |
| 4 | 1 | 0.0 | 2.0 | 3.0 | 0.0 | 0.0 | 8.375 |
| 5 | 1 | 2.0 | 0.0 | 2.0 | 1.0 | 0.0 | 9.875 |
| 6 | 1 | 2.0 | 0.0 | 2.5 | 0.0 | 0.5 | 9.875 |

Table 7.

| Characteristics of sintered ceramics | | | | | | | | |
|---|---|---|---|---|---|---|---|---|
| Composition No. | Sintering | | Resistance (Ω) | | Transition Temperature (°K) | | | XRD |
| | Temperature | Time | 150K | 15K | T1 | T2 | T3 | |
| 1 | 975 °C | 5 h | 0.070 | 0 | 105 | 100 | 103 | |
| 2 | 975 °C | 5 h | 0.018 | 0 | 111 | 103 | 105 | |
| 3 | 975 °C | 5 h | 0.052 | 0 | 110 | 102 | 103 | |
| 4 | 975 °C | 5 h | ins | | - | - | - | |
| 5 | 975 °C | 5 h | 0.016 | | 112 | 104 | 105 | |
| 6 | 975 °C | 5 h | 0.033 | | 108 | 102 | 103 | |
| 1 | +850 °C | 100 h* | 0.013 | 0 | 111 | 84 | 109 | |
| 2 | +850 °C | 100 h* | 0.034 | 0 | 118 | 115 | 116 | |
| 3 | +850 °C | 100 h* | 0.100 | 0 | 115 | 111 | 111 | |
| 4 | +850 °C | 100 h* | ins | | - | - | - | |
| 5 | +850 °C | 100 h* | 0.027 | | 117 | 112 | 113 | |
| 6 | +850 °C | 100 h* | 0.049 | | 114 | 110 | 111 | |

* sinteredd at 975 °C for 5 hours and then at 850 °C for 100 hours

As can be seen from Table 7, samples Nos. 2, 3, 5, and 6 employing partially $Tl_2O$, $Cu_2O$ and Cu metal achieved as a whole an improvement in transition temperature compared with conventional sample No. 1 employing only $Tl_2O_3$ and CuO, with the difference therebetween becoming significant particularly with the sample sintered at 975 °C for 5 hours plus at 850 °C for 100 hours. Sample No. 2 obtained the maximum onset temperature of 118 °K, and a zero resistance temperature of 115 °K. On the other hand, the sample employing no $Tl_2O_3$ but $Tl_2O$ only was insulator.

Next, the samples were ground and the produced phases were identified by powder X-ray diffraction analysis to indicate that sample No. 1 had $(Tl,Bi)Sr_2CaCu_2O_x$ phase of a low transition temperature and unknown impurity phases besides the desired $(Tl,Bi)Sr_2Ca_2Cu_3O_x$ phase formed.

On the other hand, in samples Nos. 2, 3, 5, and 6, there were formed $(Tl,Bi)Sr_2Ca_2Cu_3O_x$ phase as major phase, and a little $(Tl,Bi)Sr_2CaCu_2O_x$ phase and unknown phases. Particularly, sample No. 2 sintered at 975 °C for 5 hours plus at 850 °C for 100 hours comprised almost the $(Tl,Bi)Sr_2Ca_2Cu_3O_x$ phase alone. The sample employing no $Tl_2O_3$ but $Tl_2O$ alone comprised a small proportion of $(Tl,Bi)Sr_2CaCu_2O_x$ phase and the remainder of unknown phases.

The present inventors have made samples with varying the proportions of $Tl_2O$, $Cu_2O$ and Cu metal besides samples Nos. 2 to 6, and found that in any case, good superconductive transition could be observed in the range of $(7.5 + 1.5Z) \leqq x \leqq (8.3 + 1.5Z)$ though there was some extent of difference in transition temperature, and that samples comprising the $(Tl,Bi)Sr_2Ca_2Cu_3O_x$ phase alone were apt to be formed. Therefore, the effect on the formation of the $(Tl_{1-y},Bi_y)Sr_2Ca_2Cu_3O_x$ phase including the case of y = 0 under adjustment of a proportion of oxygen was confirmed.

## Claims

1. An oxide superconductive substance comprising a composition containing at least Tl, Bi, Sr, Ca, and Cu, having a crystalline structure of the tetragonal system with the lattice constant, a = 0.38 nm, and c = 1.53 nm

2. The oxide superconductive substance as defined in Claim 1, wherein said composition have a ratio of (Tl + Bi) : Sr : Ca : Cu equal or very close to 1 : 2 : 2 : 3, and the ratio of Tl/Bi is in the range of 5/1 to 2/1.

3. A method for producing $(Tl_{1-y},Bi_y)Sr_2Ca_2Cu_3O_x$ oxide superconductive substance comprising preparing a starting material containing metal oxide components in a ratio of $(Tl_{1-y}Bi_y)$ : Sr : Ca : Cu : O = (1 + Z) : 2 : 2 : 3: x where $0 \leqq y \leqq 1/3$, and the value of x is in the range of $(7.5 + 1.5Z) \leqq x \leqq (8.3 + 1.5Z)$, and sintering said starting material in a non-oxidizing atmosphere.

4. The method for producing oxide superconductive substance as defined in Claim 3, wherein the value of x is in the range of $(7.5 + 1.5Z) \leq x \leq (8.3 + 1.5Z)$ by employing $Tl_2O$ as a part of said starting material.

5. The method for producing oxide superconductive substance as defined in Claim 3, wherein the value of x is in the range of $(7.5 + 1.5Z) \leq x \leq (8.3 + 1.5Z)$ by employing $Cu_2O$ or Cu metal as a part of said starting material.

6. The method for producing oxide superconductive substance as defined in Claim 3, wherein the value of Z is in the range of 0 to 1.

7. The method for producing oxide superconductive substance as defined in Claim 3, wherein shaped material is placed in a sealed state, and then sintered.

8. The method for producing oxide superconductive substance as defined in Claim 3, wherein the sintering temperature is 900°C or higher, but not higher than 1000°C.

9. The method for producing oxide superconductive substance as defined in Claim 3, wherein said material is sintered at a temperature of 900°C or higher, but not higher than 1000°C, and then annealed at a temperature below 900°C.